(19) Europäisches Patentamt

European Patent Office

Office européen des brevets

(11) Numéro de publication : **0 420 742 B1**

(12) **FASCICULE DE BREVET EUROPEEN**

(45) Date de publication du fascicule du brevet :
**24.11.93 Bulletin 93/47**

(51) Int. Cl.$^5$ : **H04B 10/14, H01S 3/103**

(21) Numéro de dépôt : **90402638.2**

(22) Date de dépôt : **25.09.90**

(54) **Photorécepteur pour signaux optiques modulés en fréquence.**

(30) Priorité : **27.09.89 FR 8912646**

(43) Date de publication de la demande :
**03.04.91 Bulletin 91/14**

(45) Mention de la délivrance du brevet :
**24.11.93 Bulletin 93/47**

(84) Etats contractants désignés :
**DE GB**

(56) Documents cités :
**GB-A- 2 110 498
APPLIED PHYSICS LETTERS, vol. 54, no. 11,
13 mars 1989, pages 984-986, American Institute of Physics, New York, US; H. NAKAJIMA:
"High-speed and high-gain optical amplifying
photodetection in a semiconductor laser
amplifier"**

(56) Documents cités :
**JOURNAL OF LIGHTWAVE TECHNOLOGY,
vol. LT-1, no. 2, juin 1983, pages 394-401, IEEE,
New York, US; S. KOBAYASHI et al.:
"Automatic frequency control in a semiconductor laser and an optical amplifier"
IEEE JOURNAL OF QUANTUM ELECTRONICS,
vol. QE-17, no. 7, juillet 1981, pages 1216-1225,
IEEE, New York, US; Y. MITSUHASHI et al.:
"Voltage change across the self-coupled
semiconductor laser"**

(73) Titulaire : **FRANCE TELECOM
6, Place d'Alleray
F-75015 Paris (FR)**

(72) Inventeur : **Nakajima, Hisao
97/99, rue de la Tombe-Issoire
F-75014 Paris (FR)**

(74) Mandataire : **Mongrédien, André et al
c/o BREVATOME 25, rue de Ponthieu
F-75008 Paris (FR)**

EP 0 420 742 B1

Jouve, 18, rue Saint-Denis, 75001 PARIS

## Description

La présente invention a pour objet un photorécepteur pour signaux optiques modulés en fréquence. Elle trouve une application en télécommunications optiques et notamment dans la réalisation de réseaux multiplexés en longueur d'onde et à haute densité. Elle peut s'appliquer également, en laboratoire, à des mesures de modulation de fréquence et à la caractérisation des lasers à semi-conducteur.

Parmi les divers types de modulation employés pour les signaux optiques, la modulation dite FSK (pour "Frequency Shift Keying") occupe une place privilégiée. Elle consiste à déplacer la fréquence du signal optique émis en fonction de l'information à transmettre. Cette modulation s'obtient aisément avec un laser à semi-conducteur monofréquence en modulant le courant de polarisation. Contrairement à la modulation d'intensité, la totalité des photons émis par le laser se trouve modulée en fréquence, quelle que soit la profondeur de modulation. En d'autres termes, elle équivaut à une modulation à 100%.

La détection de signaux optiques modulés en FSK s'effectue généralement, soit par détection cohérente, soit par conversion directe en modulation d'intensité par étalon Fabry-Pérot. La première méthode nécessite un oscillateur local (généralement constitué par un laser monofréquence accordable en longueur d'onde), un photodétecteur rapide, un mélangeur de signaux et des circuits électroniques complexes (discriminateur de fréquence intermédiaire, circuit de décision, circuit de stabilisation de la fréquence intermédiaire, etc ...) ; si elle conduit à de bonnes performances, elle reste donc difficile à mettre en oeuvre. La seconde méthode ne l'est guère moins, nécessitant un circuit d'asservissement pour accorder l'une des fréquences de résonance de l'étalon avec celle du signal à démoduler. De plus, elle ne permet pas d'accorder la fréquence sur une grande plage, ce qui est incompatible avec le multiplexage en longueur d'onde à haute densité de canaux.

Sur ces problèmes de modulation et de démodulation en télécommunications optiques, on pourra consulter l'article de Yoshihisa YAMAMOTO et al., intitulé "Coherent Optical Fiber Transmission Systems", publié dans IEEE Journal of Quantum Electronics, vol. QE-17, N° 6, June 1981, pp. 919 à 935.

On connaît par ailleurs des photorécepteurs assez simples de mise en oeuvre, qui utilisent un laser à semi-conducteur dans lequel on injecte le faisceau lumineux à traiter. Ces dispositifs ne fonctionnent pas à proprement parler en démodulateurs mais plutôt en moyens de commande automatique de fréquence. Un tel dispositif est décrit, par exemple, dans l'article de Soichi KOBAYASHI et al., intitulé "Automatic Frequency Control in a Semiconductor Laser and an Optical Amplifier", publié dans "Journal of Lightwave Technology", vol. LT-1, N° 2, June 1983, pp. 394-401 et dans l'article de Soichi KOBAYASHI et al., intitulé "Injection Locking Characteristics of an AlGaAs Semiconductor Laser", publié dans IEEE Journal of Quantum Electronics, vol. QE-16, N° 9, September 1980, pp. 915 à 917.

Comme l'invention qui va être décrite reprend certains éléments de cette technique connue, il n'est pas inutile d'en rappeler les caractéristiques essentielles.

La technique décrite dans les articles cités utilise un laser à semi-conducteur dans lequel on injecte le faisceau lumineux à traiter (technique dite "Optical-Injection-Locking"). Le laser est alimenté en courant au voisinage du seuil (c'est-à-dire pratiquement entre 0,7 fois et 1,3 fois le courant de seuil). Le laser fonctionne alors en régime d'amplificateur. On parle d'"injection-locked amplifier" (ILA) ou de "resonant-type amplifier" (RTA). Le laser émettant le rayonnement est dit laser "maître" et le laser dans lequel le rayonnement est injecté est dit laser "esclave".

Le laser esclave fonctionne dans une certaine bande de fréquence. Le faisceau injecté subit, à la traversée de la couche active de l'amplificateur, une amplification qui est plus ou moins importante selon la place occupée par la fréquence du faisceau dans la bande d'amplification. Cette amplification est maximale au centre de la bande et décroît de part et d'autre.

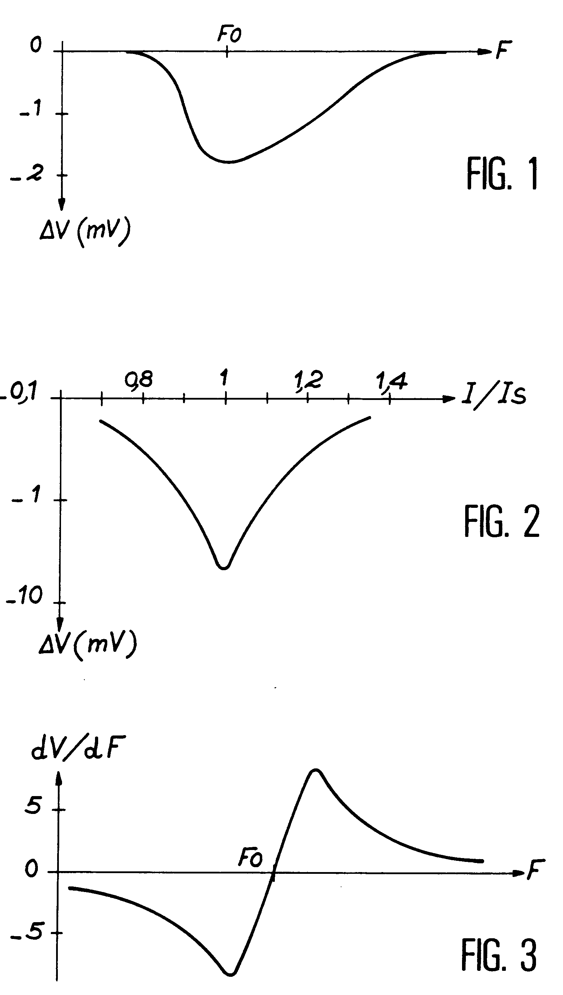

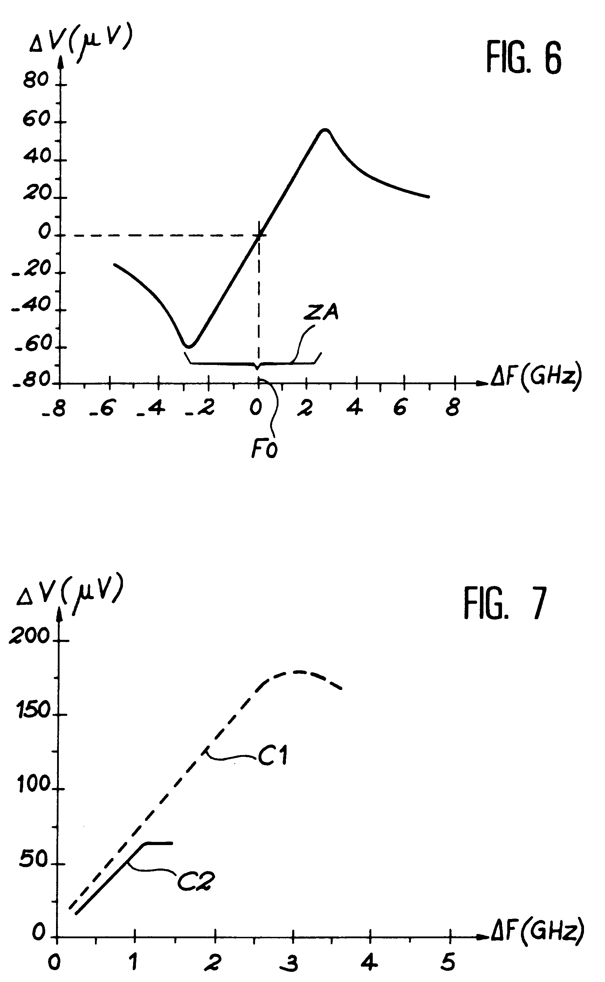

L'injection de photons dans la couche active a pour effet d'augmenter sensiblement la densité de photons, et corrélativement, la puissance optique produite. Il en résulte que la tension aux bornes du laser diminue légèrement. Comme l'indique la courbe de la figure 1 annexée (qui reproduit sensiblement l'une des courbes de la figure 6 du premier article de KOBAYASHI cité), la diminution de tension V présente une forme résonnante (c'est-à-dire en cloche inversée) avec un minimum (ou, si l'on veut, un maximum d'écart de tension) lorsque la fréquence F du signal optique injecté provenant du laser maître est égale à la fréquence centrale Fo de la bande d'amplification du laser esclave. Cet écart de tension diminue lorsque la fréquence F s'éloigne de Fo pour s'annuler lorsque la fréquence F sort de la zone dite d'accrochage ("locking").

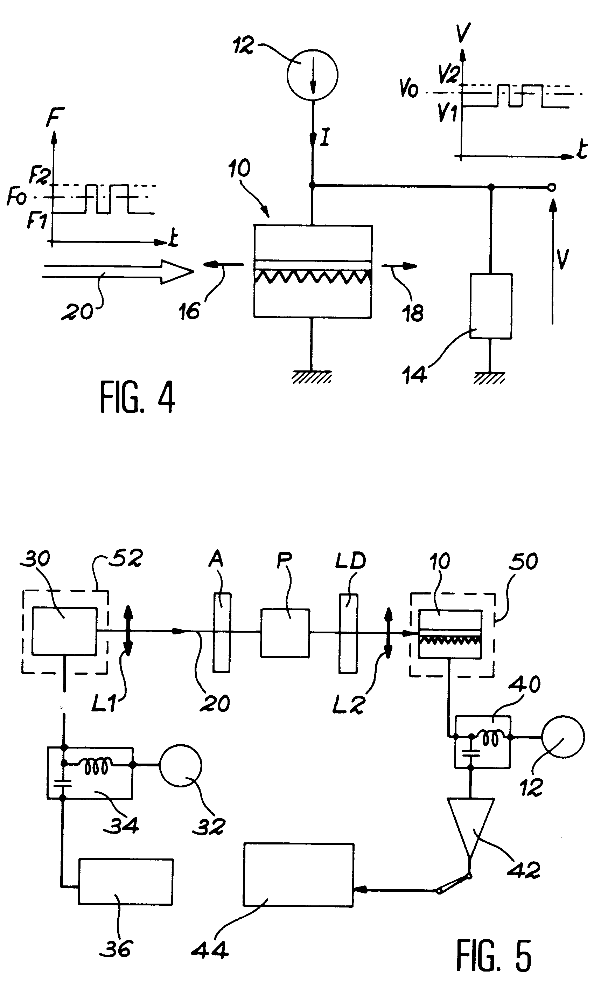

Naturellement, ce phénomène est lié à la valeur du courant de polarisation du laser esclave. La figure 2 (qui reproduit sensiblement l'une des courbes de la figure 4 du document précité) montre la variation de tension $\Delta V$ en fonction du rapport I/Io. Cette variation est d'autant plus grande que le courant de polarisation est proche du courant de seuil (I/Is=1). La variation de tension devient quasiment nulle lorsque le laser esclave est polarisé par un courant supérieur à 1,3 ou 1,4 fois le courant de seuil. (On notera l'échelle logarithmique en ordonnées). En extrapolant à deux fois le seuil, on trouverait une variation de tension d'environ 1/100 de millivolt, qui serait inexploitable.

C'est la raison pour laquelle, dans cette technique, on se place toujours au voisinage du seuil (la plupart des mesures rapportées dans l'article visé correspondent à un courant de polarisation égal à 1,1 fois le courant de seuil).

On conçoit qu'une variation de tension comme celle de la figure 1 puisse permettre un asservissement de fréquence : si la fréquence F du laser maître est prise comme référence, en prenant la variation de la tension aux bornes du laser esclave comme signal d'erreur, on pourra ramener la fréquence centrale Fo du laser esclave à la fréquence F, par exemple en modifiant la température du laser esclave.

Si, inversement, on voulait connaître les variations de la fréquence du signal injecté par rapport à la fréquence Fo, il faudrait dériver la variation de tension représentée sur la figure 1. On obtiendrait alors une courbe telle que celle de la figure 3, qui correspond sensiblement à l'une des courbes de la figure 12 du document cité.

Cette opération supplémentaire de dérivation est une complication. On s'en dispense en fait puisque cette méthode reste un moyen de stabilisation de fréquence d'un laser esclave par rapport à un laser maître et non un dispositif de démodulation de fréquence.

On retiendra que, dans cette technique connue, le laser à semi-conducteur esclave fonctionne en amplificateur, au voisinage du seuil et que la tension prélevée à ses bornes subit toujours une variation négative en forme de cloche, la variation de tension mesurée ne donnant que l'amplitude de l'écart de fréquence mais non son signe.

La présente invention reprend, à certains égards, cette technique, mais en la mettant en oeuvre de manière originale de telle manière que la tension prélevée aux bornes du laser esclave représente l'écart de fréquence non seulement en grandeur mais aussi en signe. Il n'est donc plus besoin d'effectuer une dérivation du signal prélevé. De manière surprenante et très avantageusement, la modulation de fréquence du signal incident se traduit directement par une modulation de tension.

Ce résultat est obtenu en faisant fonctionner le laser photorécepteur (ou esclave) très nettement au-dessus du seuil, c'est-à-dire, en pratique, à plus de deux fois le seuil. Dans ces conditions, le laser ne fonctionne plus en amplificateur, comme dans l'art antérieur, mais en oscillateur. Il possède alors une fréquence propre d'oscillation Fo (ou une longueur d'onde propre λo). L'introduction d'un faisceau lumineux dans la couche active de cet oscillateur ne modifie pas sensiblement la densité de photons, laquelle est déjà très grande du fait du régime de fonctionnement en oscillation largement au-dessus du seuil. Le phénomène décrit plus haut à propos de l'art antérieur, s'il existe, est insignifiant. D'ailleurs, comme indiqué, la courbe de la figure 2 montre qu'en se plaçant deux fois au-dessus du seuil, le phénomène en question disparaît quasiment.

Un autre mécanisme apparaît, qui met en jeu des phénomènes tout autres : sous l'effet de l'injection du faisceau à la fréquence F différente de Fo, l'oscillateur va voir sa fréquence glisser ; ce glissement de fréquence est rendu possible par une variation de l'indice de réfraction de la couche active. Cette variation $\Delta F = F - Fo$ est positive ou négative selon la place de F par rapport à Fo. Si F est inférieur à Fo, (autrement dit si la longueur d'onde λ est supérieure à λo), l'indice de réfraction augmente et la fréquence de l'oscillateur va se caler sur F. Cette augmentation d'indice est obtenue par une diminution de densité de porteurs dans la couche active. Si l'indice diminue, la densité de porteurs va augmenter car le rapport variation d'indice par unité de variation de densité de porteur ($\frac{dn}{dN}$) est négatif, et inversement. Mais la densité de porteurs détermine par ailleurs la séparation des quasi-niveaux de Fermi dans la couche active et cette dernière correspond à la tension aux bornes de la jonction pn du laser. Cette tension va donc diminuer lorsque F sera inférieur à Fo et augmenter si F est supérieur à Fo. Elle restera inchangée si F=Fo.

On obtient ainsi une variation de tension qui, en grandeur et en signe, correspond à l'écart entre la fréquence F du faisceau incident et la fréquence propre Fo de l'oscillateur laser de référence.

On aura noté les différences essentielles avec le phénomène mis en jeu dans l'art antérieur : alors que dans celui-ci la variation de tension était toujours négative et maximale pour F=Fo, dans l'invention la variation est tantôt positive, tantôt négative et est nulle pour F=Fo. Dans l'invention, le photorécepteur détecte directement l'écart de fréquence, sans qu'il soit besoin de recourir à un circuit de dérivation auxiliaire.

Les performances de ce nouveau photorécepteur sont donc très intéressantes. A titre explicatif, le Demandeur a obtenu les résultats suivants :
- sélectivité en longueur d'onde : 0,04 nm pour une puissance optique de -30dBm,
- bande passante électrique supérieure à 2GHz,
- sensibilité : -30dBm,
- facteur de conversion de fréquence en tension (dV/dF) : 50 µV/GHz environ à 750 MHz,
- accord en longueur d'onde par changement de température : 0,065 nm/°C et par changement de courant de polarisation : 0,013 nm/mA,
- dimensions : 0,4 x 0,1 x 0,3 mm³.

De façon plus précise, l'invention a pour objet un photorécepteur pour signaux optiques modulés en fréquence, comprenant un laser à semi-conducteur monofréquence avec une couche active, un courant de seuil et une fréquence propre, une source de courant de polarisation alimentant le laser au-dessus du seuil, des moyens optiques pour injecter un faisceau lumineux modulé en fréquence dans la couche active du laser, un moyen pour prélever la tension électrique aux bornes du laser, ce photorécepteur étant caractérisé par le fait que le courant d'alimentation produit par la source de courant est réglé à une valeur très supérieure au seuil laser, le laser fonctionnant alors en oscillateur, le moyen pour prélever la tension délivrant alors une tension présentant, par rapport à la tension propre prélevée en l'absence de faisceau injecté, une variation dont l'amplitude est proportionnelle à l'écart entre la fréquence du faisceau injecté et la fréquence propre du laser et un signe qui est celui dudit écart de fréquence, la modulation de fréquence du faisceau lumineux injecté étant ainsi traduite directement en modulation d'amplitude de la tension prélevée aux bornes du laser.

De préférence, le courant d'alimentation du laser est supérieur à deux fois le courant de seuil.

De toute façon, les caractéristiques et avantages de l'invention apparaîtront mieux à la lumière de la description qui va suivre. Cette description se réfère à des dessins annexés sur lesquels :
- la figure 1, déjà décrite, montre la variation de tension obtenue selon l'art antérieur en fonction de la fréquence,
- la figure 2, déjà décrite, montre la variation de tension obtenue selon l'art antérieur en fonction du courant de polarisation,
- la figure 3, déjà décrite, montre la dérivée de la tension obtenue selon l'art antérieur,
- la figure 4 illustre le principe de fonctionnement du photorécepteur de l'invention,
- la figure 5 montre un montage expérimental utilisant le photorécepteur de l'invention,
- la figure 6 illustre les variations de la tension prélevée aux bornes du laser en fonction de l'écart de fréquence,
- la figure 7 montre deux cas particuliers de cette variation de tension à deux puissances optiques différentes,

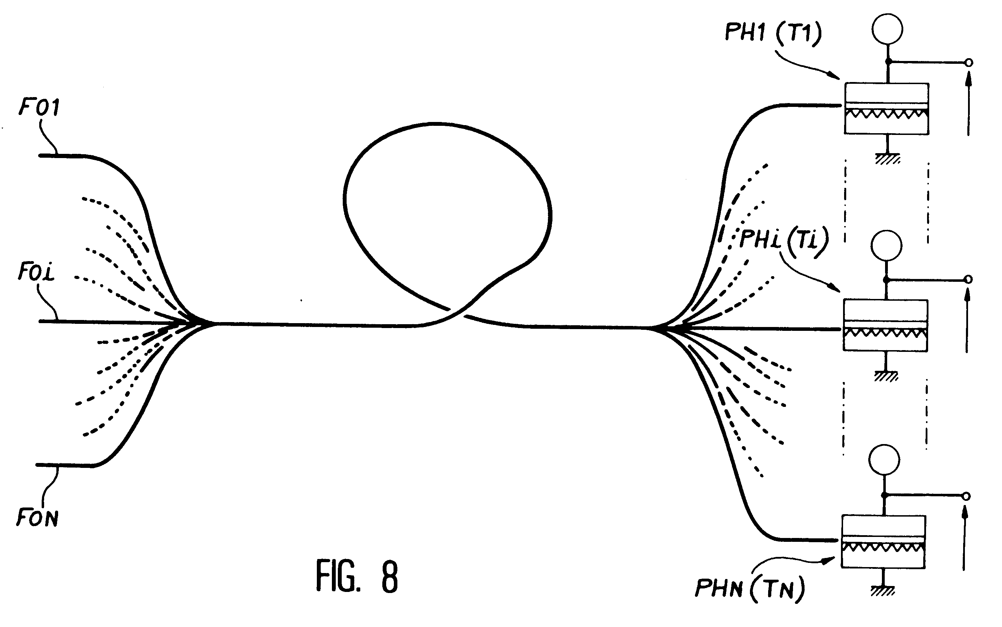

- la figure 8 montre un dispositif de multiplexage démultiplexage utilisant une pluralité de photorécepteurs selon l'invention.

On voit sur la figure 4 un laser 10, par exemple du type à réaction distribuée ("Distributed Feedback"). Un tel laser est constitué classiquement d'un empilement de couches semi-conductrices, avec notamment une couche active encadrée par deux couches de confinement et un réseau distribué. Le semi-conducteur peut appartenir à la famille des composés de III-V, de type binaire, ternaire ou quaternaire, comme par exemple InGaAsP sur InP. Le laser est alimenté par une source de courant 12 et il est équipé d'un moyen 14 apte à mesurer la tension à ses bornes.

Le courant I injecté est supérieur à deux fois le courant de seuil Is du laser. Le laser est ainsi placé dans son régime de fonctionnement en oscillateur. Il émet un rayonnement lumineux 16, 18 de longueur d'onde $\lambda$o (ou de fréquence Fo).

Les intensités relatives des rayonnements 16 et 18 dépendent des coefficients de réflexion des faces du laser. Il n'est pas utile de préciser ces conditions, qui n'ont pas de rapport direct avec l'invention.

Un faisceau lumineux 20, de fréquence F, (ou de longueur d'onde $\lambda$ ) est injecté dans le laser 10. Sa fréquence est censée être modulée. A titre explicatif est représenté, sur la gauche du dessin, un diagramme montrant que la fréquence peut prendre deux valeurs F1 et F2 (F1 peut correspondre à un 0 logique et F2 à un 1 logique, dans un système d'information binaire).

La tension V, prélevée aux bornes du laser par l'appareil 14, prend alors deux valeurs V1 et V2 représentées sur la partie droite et correspondant aux deux fréquences F1 et F2.

Dans cet exemple, on a supposé que les fréquences F1 et F2 encadraient la fréquence propre Fo du laser, F2 étant supérieure à Fo. Dans cette hypothèse et conformément aux explications données plus haut, la fréquence de fonctionnement du laser récepteur va glisser vers F1 ou vers F2 sous l'effet de l'injection du faisceau 20, ce qui va décaler la tension de fonctionnement vers le bas ou vers le haut. La différence avec l'art antérieur apparaît donc clairement puisque dans ce dernier, la variation de tension était toujours négative. Avec deux fréquences également écartées de la fréquence propre du laser, on obtiendrait, dans l'art antérieur, sensiblement à la même tension aux bornes du laser, ce qui entraînerait une sérieuse difficulté pour les discriminer.

La figure 5 montre un montage expérimental permettant d'étudier le photorécepteur de l'invention. On y retrouve le laser 10 alimenté par la source 12. Est représenté en outre un laser 30 jouant le rôle d'émetteur, ce laser étant alimenté par une source de courant 32 à travers un "T" 34 comprenant une inductance et un condensateur, celui-ci étant relié à un oscillateur haute fréquence 36. Le courant injecté dans le laser 30 est ainsi modulé en intensité. Il en résulte que le faisceau lumineux émis est modulé en fréquence autour d'une fréquence moyenne.

Des moyens optiques sont en outre prévus pour injecter le faisceau modulé dans le laser 10 jouant le rôle de photorécepteur. Ces moyens comprennent une première lentille L1, un atténuateur A, un polariseur P, une lame demi-onde LD et une seconde lentille L2 pouvant être un objectif de microscope. Les moyens A, P et LD remplissent la fonction d'isolateur optique.

Quant aux moyens de mesure de la tension aux bornes du laser, ils comprennent, après un "T" 40 constitué d'une inductance et d'un condensateur, un amplificateur 42 et un analyseur de spectre 44. Cet analyseur donne l'intensité de la composante de tension à la fréquence de modulation du générateur 36.

Le montage comprend encore des moyens de stabilisation en température des lasers, représentés schématiquement par les rectangles en tirets 50 et 52.

Un tel montage a permis au Demandeur de mesurer un certain nombre de grandeurs, représentées sur les figures 6 et 7. Dans ces mesures, le courant de polarisation des lasers émetteur et récepteur était respectivement de 35 et 49 mA, soit 2,2 fois le courant de seuil. La température des lasers était stabilisée à 20°C. La fréquence optique du laser émetteur (ou du laser récepteur) pouvait être déplacée par variation de température. La modulation du laser émetteur était obtenue par modulation du courant de polarisation.

Sur la figure 6, tout d'abord, est représentée la variation de tension ΔV exprimée en microvolts et portée en ordonnées, en fonction de l'écart de fréquence ΔF exprimée en gigahertz, écart entre la fréquence F du laser émetteur 30 et la fréquence propre Fo du laser récepteur 10.

La courbe représentée correspond à une puissance injectée de -30dBm.

La zone marquée ZA correspond à la plage d'accrochage, c'est-à-dire la plage où le photorécepteur est forcé à la fréquence du faisceau injecté. Dans cette plage, la relation tension-fréquence est linéaire. En dehors de cette plage, l'écart F-Fo est trop important pour que l'oscillateur puisse s'accrocher sur la fréquence de l'onde injectée. Il reprend ses conditions naturelles d'oscillation à la fréquence Fo et la tension reprend sa valeur nominale.

La figure 7 donne des courbes semblables pour une fréquence de modulation égale à 750MHz. La courbe C1 correspond à une puissance optique injectée de -30dBm soit 1 μW et la courbe C2 à -40dBm, soit 0,1 μW.

Le taux de conversion est d'environ 52 V/GHz.

En modifiant la température du photorécepteur ou son courant de polarisation, il est possible de déplacer la fréquence propre Fo et, par conséquent, la zone d'accrochage. On peut ainsi utiliser le même type de photorécepteur mais sur diverses longueurs d'onde, ce qui est utile dans un système multiplexé. C'est ce qui est représenté sur la figure 8 où l'on voit une pluralité de N fibres optiques FO1, ..., FOi, ... FON transportant des signaux optiques respectivement à la longueur d'onde λ1, ..., λi, ...λN et, côté réception, une même pluralité de N photorécepteurs PH1, ..., PHi, ..., PHN stabilisés à des températures T1, ..., Ti, ..., TN pour fonctionner aux longueurs d'onde λ1, ..., λi, ..., λN.

Naturellement, dans la description qui précède, ce n'est qu'à titre explicatif qu'on a mentionné les lasers DFB. Tout autre laser peut être utilisé, y compris les lasers à couche active- puits quantiques, à électrodes multiples (la puce laser est alimentée par plusieurs électrodes séparées), et à multi-sections (composés des sections amplificatrice, guide et réflectrice).

## Revendications

1. Photorécepteur pour signaux optiques modulés en fréquence, comprenant un laser à semi-conducteur (10) monofréquence avec une couche active, un courant de seuil et une fréquence propre (Fo), une source de courant de polarisation (12) alimentant le laser (10) au-dessus ou seuil, des moyens optiques (L1, A, P, LD, L2) pour injecter un faisceau lumineux (20) modulé en fréquence dans la couche active du laser, un moyen (14) pour prélever la tension électrique aux bornes du laser (10), ce photorécepteur étant caractérisé par le fait que le courant d'alimentation (I) produit par la source de courant (12) est réglé à une valeur très supérieure au seuil laser, le laser (10) fonctionnant alors en oscillateur, le moyen (14) pour prélever la tension délivrant alors une tension (V) présentant, par rapport à la tension propre (Vo) prélevée en l'absence de faisceau injecté, une variation (ΔV) dont l'amplitude est proportionnelle à l'écart entre la fréquence (F) du faisceau injecté et la fréquence propre (Fo) du laser (10) et un signe qui est celui dudit écart de fréquence, la modulation de fréquence du faisceau lumineux injecté (20) étant ainsi traduite directement en modulation d'amplitude (ΔV) de la tension prélevée aux bornes du laser (10).

2. Photorécepteur selon la revendication 1, caractérisé par le fait que le courant d'alimentation du laser est supérieur à deux fois le courant de seuil.

3. Photorécepteur selon la revendication 1, caractérisé par le fait qu'il comprend des moyens (12, 50) pour régler la fréquence propre du laser à une valeur déterminée.

4. Photorécepteur selon la revendication 3, caractérisé par le fait que les moyens pour régler la fréquence propre du laser sont des moyens (50) de régulation de la température.

5. Photorécepteur, caractérisé en ce qu'il comprend une pluralité de photorécepteurs (PH1, ..., PHi, ..., PHN) selon la revendication 3, chacun associé à un laser réglé sur une fréquence propre particulière.

6. Photorécepteur selon la revendication 1, caractérisé par le fait que le laser est du type à réaction distribuée (DFB).

7. Photorécepteur selon la revendication 1, caractérisé par le fait que le laser est du type à puits quantiques.

8. Photorécepteur selon la revendication 1, caractérisé par le fait que le laser est du type à électrodes multiples.

9. Photorécepteur selon la revendication 1, caractérisé par le fait que le laser est du type à multisections.

## Patentansprüche

1. Fotoempfänger für frequenzmodulierte optische Signale, umfassend einen monofrequenten Halbleiterlaser (10) mit einer aktiven Schicht, einer Stromschwelle und einer Eigenfrequenz (Fo), eine Polarisationsstromquelle (12), die den Laser (10) oberhalb der Schwelle versorgt, optischen Einrichtungen (L1, A, P, LD, L2) zum Eingeben eines frequenzmodulierten Lichtstrahls (20) in die aktive Schicht des Lasers, Vorrichtung (14) zum Abgreifen der elektrischen Spannung an den Anschlüssen des Lasers (10), wobei dieser Fotoempfänger **dadurch gekennzeichnet** ist, daß der Versorgungsstrom (I), der durch die Stromquelle (12) erzeugt wird, auf einen Wert weit oberhalb der Laserschwelle geregelt ist, wodurch der Laser (10) folglich als Oszillator arbeitet, wobei die Vorrichtung (14) zum Abgreifen der Spannung demnach eine Spannung (V) liefert, die in Bezug auf die Eigenspannung (Vo), die in Abwesenheit eines eingegebenen Strahls abgegriffen wird, eine Variation ( V), wiedergibt, deren Amplitude proportional zur Abweichung zwischen der Frequenz (F) des eingegebenen Strahls und der Eigenfrequenz (Fo) des Lasers (10) ist, und ein Vorzeichen, das demjenigen der besagten Frequenzabweichung gleich ist, wobei die Frequenzmodulation des eingegebenen Lichtstrahles (20) sich dadurch direkt in eine Amplitudenmodulation ( V) der Spannung überträgt, die an den Anschlüssen des Lasers abgegriffen wird.

2. Fotoempfänger nach Anspruch 1, **dadurch gekennzeichnet, daß** der Versorgungsstrom des Lasers mehr als das zweifache des Schwellenstromes beträgt.

3. Fotoempfanger nach Anspruch 1, **dadurch gekennzeichnet, daß** er Einrichtungen (12, 50) zum Regeln der Eigenfrequenz des Lasers auf einen vorbestimmten Wert umfaßt.

4. Fotoempfänger nach Anspruch 3, **dadurch gekennzeichnet, daß** die Vorrichtungen zum Regeln der Eigenfrequenz des Lasers Einrichtungen (50) zur Regulation der Temperatur umfassen.

5. Fotoempfänger, **dadurch gekennzeichnet, daß** er eine Anzahl von Fotoempfängern (PH1,...,

PHi, ..., PHN) gemäß Anspruch 3 umfaßt, wobei jeder mit einem Laser verbunden ist, der auf eine besondere Eigenfrequenz geregelt ist.

6. Fotoempfänger nach Anspruch 1, **dadurch gekennzeichnet, daß** der Laser von dem Typ der verteilten Rückwirkung (DFB) ist.

7. Fotoempfänger nach Anspruch 1, **dadurch gekennzeichnet, daß** der Laser von dem Typ der Quantensenken ist.

8. Fotoempfänger nach Anspruch 1, **dadurch gekennzeichnet, daß** der Empfänger von dem Typ von multiplen Elektroden ist.

9. Fotoempfänger nach Anspruch 1, **dadurch gekennzeichnet, daß** der Laser von dem Typ von Multisektionen ist.

## Claims

1. Photoreceptor for frequency-modulated optical signals and including a monofrequency semiconductor laser (10) with an active layer, a threshold current and an actual frequency, (Fo), a polarization current source (12) feeding the laser (10) beyond the threshold, optical means (L1,A,P,LD,L2) to inject a frequency-modulated luminous beam (20) into the active layer of the laser, a device (14) to appropriate the electric voltage at the laser (10) terminals, this photoreceptor being characterized in that the feed current (I) produced by the current source (12) is adjusted to a value much higher than the laser threshold, the laser (10) then functioning as an oscillator, the device (14) taking up the voltage then delivering a voltage (V) exhibiting, with respect to the actual voltage (Vo) appropriated in the absence of the injected beam, a variation whose amplitude is proportional to the difference between the frequency (F) of the injected beam and the actual frequency (Fo) of the laser (10) and a sign, namely that of the frequency difference, the frequency modulation of the injected luminous beam (20) being thus directly translated into amplitude modulation ($\Delta V$) of the voltage appropriated at the laser (10) terminals.

2. Photoreceptor according to claim 1, characterized in that the feed current of the laser is twice greater than the threshold current.

3. Photoreceptor according to claim 1, characterized in that it includes means (12,50) to adjust the actual frequency of the laser to a specific value.

4. Photoreceptor according to claim 3, characterized in that the means to adjust the actual frequency of the laser are temperature adjustment means (50).

5. Photoreceptor, characterized in that it includes a plurality of photoreceptors (PH1 .... PHi .... PHN) according to claim 3, each associated with a laser adjusted on a particular frequency.

6. Photoreceptor according to claim 1, characterized in that the laser is of the distributed feedback (DFB) type.

7. Photoreceptor according to claim 1, characterized in that the laser is of the quantum well type.

8. Photoreceptor according to claim 1, characterized in that the laser is of the multiple electrode type.

9. Photoreceptor according to claim 1, characterized in that the laser is of the multisection type.

FIG. 1

FIG. 2

FIG. 3

FIG. 4

FIG. 5

FIG. 6

ΔV(μV)

ZA

F0

ΔF(GHz)

FIG. 7

ΔV(μV)

C1

C2

ΔF(GHz)

FIG. 8

FO1

FOi

FON

PH1 (T1)

PHi (Ti)

PHN (TN)

EP 0 420 742 B1